# FASCICULE DE BREVET EUROPEEN

(11) **EP 3 062 350 B1**
(45) Date de publication et mention de la délivrance du brevet: **14.03.2018**
(21) Numéro de dépôt: 16156850.6
(22) Date de dépôt: 23.02.2016
(51) Int. Cl.: H01L 29/66, H01L 29/786, H01L 29/423, H01L 29/78, H01L 21/02, H01L 21/311, H01L 29/06, H01L 21/3065

(54) **PROCEDE DE MODIFICATION DE L'ETAT DE CONTRAINTE D'UNE STRUCTURE SEMI-CONDUCTRICE A ETAGES DE CANAL DE TRANSISTOR**
VERFAHREN ZUR VERÄNDERUNG DES SPANNUNGSZUSTANDS EINER HALBLEITERSTRUKTUR MIT TRANSISTORKANALSTUFEN
METHOD FOR MODIFYING THE STATE OF STRESS OF A SEMICONDUCTOR STRUCTURE WITH TRANSISTOR CHANNEL STAGES

(30) Priorité: 24.02.2015 FR 1551566
(43) Date de publication de la demande: 31.08.2016
(73) Titulaire: Commissariat à l'Énergie Atomique et aux Énergies Alternatives, 75015 Paris (FR)
(72) Inventeur: MAITREJEAN, Sylvain, 38000 GRENOBLE (FR); AUGENDRE, Emmanuel, 38330 MONTBONNOT (FR); BARBE, Jean-Charles, 38160 IZERON (FR); MATHIEU, Benoit, 38000 GRENOBLE (FR); MORAND, Yves, 38000 GRENOBLE (FR)
(74) Mandataire: Brevalex

(56) Documents cités:
- WO-A1-2013/095341
- US-A1- 2014 097 502
- US-A1- 2014 099 793
- US-A1- 2015 044 826

## Description

### DOMAINE TECHNIQUE ET ART ANTÉRIEUR

La présente invention se rapporte au domaine de la micro-électronique et plus particulièrement à celui des transistors dotés d'une structure semi-conductrice de canal à étages c'est-à-dire formée d'éléments semi-conducteurs, tels que des nano-fils, ou des barreaux, ou des membranes, disposé(e)s les un(e)s au-dessus des autres.

Pour améliorer les performances des transistors, on peut prévoir de réaliser leur région de canal dans un matériau semi-conducteur ayant une contrainte mécanique en tension ou en compression.

Une contrainte en tension induite par exemple dans un canal de transistor en silicium permet d'obtenir une augmentation de la vitesse des électrons, tandis que lorsqu'un canal de silicium subit une contrainte en compression, on augmente la vitesse de conduction par trous. Les documents US2014/099793-A1 et US2015/044826-A1 décrivent des procédés de fabrication de transistor en ailette avec un canal contraint.

On sait réaliser un dispositif microélectronique comprenant sur un même substrat un premier transistor de type N à structure de canal planaire prévue dans un matériau ayant une contrainte en tension et un deuxième transistor de type P comportant une région de canal dans un matériau relaxé ou ayant une contrainte en compression.

Le document US2008/0169508A1 donne un exemple de procédé dans lequel on contraint différemment des blocs de silicium sur un même substrat.

Pour améliorer le contrôle du canal des transistors et améliorer leur densité d'intégration, on sait fabriquer des structures de canal de transistor à étages.

Il se pose le problème de pouvoir moduler l'état de contrainte de telles structures.

### EXPOSÉ DE L'INVENTION

Un mode de réalisation de la présente invention concerne un procédé de de modification de l'état de contrainte d'une structure de canal à étages d'un premier transistor, cette structure étant formée d'éléments semi-conducteurs disposés les uns au-dessus des autres, le procédé comprenant des étapes consistant à :
a) prévoir sur un substrat, au moins une première structure semi-conductrice formée d'un empilement semi-conducteur comprenant une alternance d'éléments à base d'au moins un premier matériau semi-conducteur et d'éléments à base d'au moins un deuxième matériau semi-conducteur différent du premier matériau semi-conducteur, puis
b) retirer par gravure sélective des portions du deuxième matériau semi-conducteur, les portions retirées du deuxième matériau semi-conducteur formant un ou plusieurs espaces vides,
c) remplir les espaces vides à l'aide d'un matériau diélectrique,
d) former, sur la première structure : une zone de mise en contrainte à base d'un premier matériau contraint ayant une contrainte intrinsèque,
e) effectuer un recuit thermique adapté de sorte à faire fluer le matériau diélectrique, et entrainer une modification d'un état de contrainte des éléments à base du premier matériau semi-conducteur dans la première structure.

Un tel procédé s'adapte à la fabrication d'un dispositif doté du premier transistor et d'au moins un deuxième transistor ayant une deuxième structure de canal à éléments semi-conducteurs disposés les uns au-dessus des autres, la deuxième structure semi-conductrice étant prévue à l'étape a) dans l'empilement semi-conducteur et comprenant également une alternance d'éléments à base d'au moins un premier matériau semi-conducteur.

Dans ce cas, l'étape d) de réalisation de la zone de mise en contrainte peut comprendre des étapes de :
- dépôt du premier matériau contraint sur la première structure et sur la deuxième structure, puis de
- retrait du premier matériau contraint sur la deuxième structure.

La première structure du premier transistor et la deuxième structure du deuxième transistor peuvent être ainsi contraintes différemment.

Le procédé peut comprendre en outre la formation sur la deuxième structure d'une autre zone de mise en contrainte à base d'un deuxième matériau contraint ayant une contrainte intrinsèque opposée à celle du premier matériau contraint.

Par contrainte opposée on entend que lorsque le premier matériau contraint a une contrainte intrinsèque en tension, le deuxième matériau contraint a une contrainte intrinsèque en compression et inversement.

La réalisation de cette autre zone de mise en contrainte peut comprendre des étapes de :
- dépôt du deuxième matériau contraint sur la première structure et sur la deuxième structure, puis de
- retrait du deuxième matériau contraint sur la première structure.

On peut ensuite effectuer un recuit thermique adapté pour faire fluer le matériau diélectrique, et entrainer une modification d'un état de contrainte des éléments à base du premier matériau semi-conducteur dans la deuxième structure. Ce recuit peut être réalisé pendant l'étape e), en même temps que celui mis en oeuvre pour modifier l'état de contrainte de la première structure.

Selon une possibilité de mise en oeuvre du procédé, la première structure et la deuxième structure prévues à l'étape a) peuvent être rattachées entre elles par le biais d'au moins un bloc d'ancrage.

Ce bloc d'ancrage peut être retiré préalablement à l'étape e).

Avantageusement, le bloc d'ancrage peut être retiré après l'étape d) de formation de la zone de mise en contrainte par gravure en se servant de cette zone de mise en contrainte comme d'un masque de protection à cette gravure.

Selon une possibilité de mise en oeuvre du procédé, le substrat prévu à l'étape a) peut être un substrat de type semi-conducteur contraint sur isolant doté d'une couche semi-conductrice superficielle contrainte. Dans ce cas, la modification d'état de contrainte à l'étape e) peut consister en une relaxation des éléments à base du premier matériau semi-conducteur.

Selon une autre possibilité de mise en oeuvre du procédé, le substrat prévu à l'étape a) peut être un substrat de type semi-conducteur contraint sur isolant doté d'une couche semi-conductrice superficielle relaxée. Dans ce cas, la modification d'état de contrainte à l'étape e) peut consister en une augmentation d'un état de contrainte en tension ou en compression induit par la zone de mise en contrainte dans les éléments à base du premier matériau semi-conducteur.

Lorsque la zone de mise en contrainte est prévue pour induire une contrainte en tension dans les éléments à base du premier matériau semi-conducteur, la modification d'état de contrainte à l'étape e) peut être une augmentation de la contrainte en tension dans les éléments à base du premier matériau semi-conducteur.

Selon une possibilité de mise en oeuvre du procédé, le matériau diélectrique de remplissage des espaces vides peut être à base de SiO₂ ou d'oxyde de silicium dopé en particulier au Bore et/ou au Phosphore.

Selon une possibilité de mise en oeuvre du procédé le premier matériau semi-conducteur peut être du Si tandis que le deuxième matériau semi-conducteur est du Si₁₋ₓGeₓ avec x > 0.

Selon une possibilité de mise en oeuvre du procédé, le premier matériau semi-conducteur peut être du Si_{1-y}Gey avec y > 0 tandis que le deuxième matériau semi-conducteur est du Si.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A-1M illustrent un premier exemple de procédé suivant un mode de réalisation de l'invention, permettant de relaxer une structure semi-conductrice à étages de canal d'un premier transistor ;
Les figures 2A-2B illustrent une variante de réalisation du premier exemple de procédé ;
Les figures 3A-3C illustrent un deuxième exemple de procédé permettant d'augmenter la contrainte dans une structure semi-conductrice à étages de canal d'un deuxième transistor ;
La figure 4 illustre une variante dans lequel le premier exemple et le deuxième exemple de procédé sont combinées afin de de relaxer une structure semi-conductrice à étages de canal d'un premier transistor tout en augmentant la contrainte dans une structure semi-conductrice à étages de canal d'un deuxième transistor;
La figure 5 illustre une variante d'agencement d'une zone de mise en contrainte formée sur la structure semi-conductrice à étages ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme pour rendre les figures plus lisibles.

En outre, dans la description ci-après, des termes qui dépendent de l'orientation, telle que « sur », « au-dessus », « supérieure », « latérale » etc. d'une structure s'appliquent en considérant que la structure est orientée de la façon illustrée sur les figures.

### EXPOSÉ DÉTAILLÉ DE MODES DE RÉALISATION PARTICULIERS

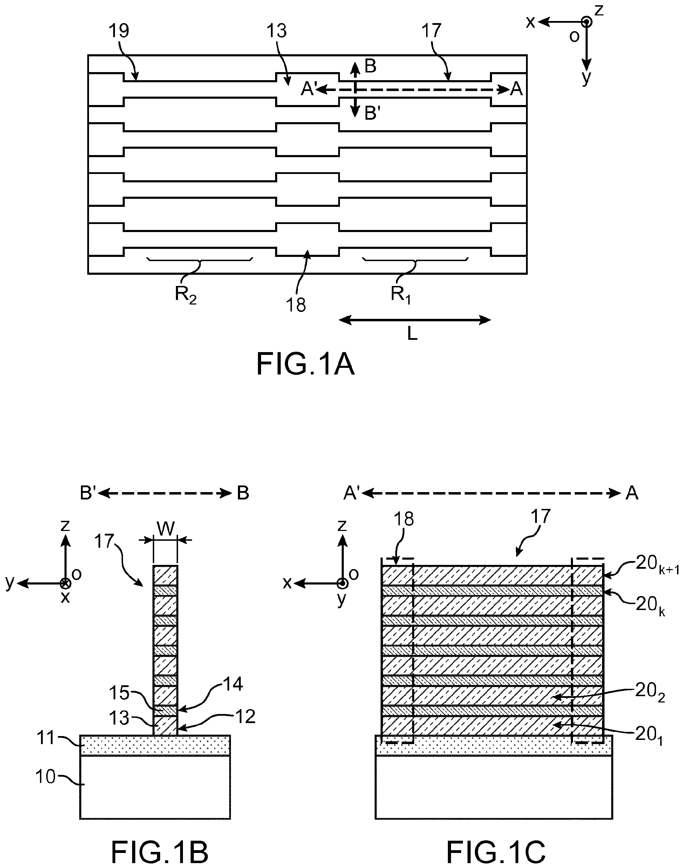

Un exemple de procédé de réalisation d'un dispositif ayant une première structure de canal à étages d'un transistor d'un premier type et une deuxième structure de canal à étages d'un transistor d'un deuxième type, va à présent décrit en liaison avec les figures 1A-1M.

Les figures 1A-1C illustrent un dispositif de départ possible pour réaliser cet exemple de procédé à partir d'un substrat de type semi-conducteur contraint sur isolant, par exemple de type sSOI (pour « strained Silicon on Insulator ou « silicium contraint sur isolant).

Ce substrat comprend ainsi une couche de support 10 semi-conductrice revêtu d'une couche isolante 11 qui peut être à base d'oxyde de silicium. Le substrat comporte également une couche semi conductrice 12 dite « superficielle » située sur et en contact de la couche isolante 11. La couche semi-conductrice 12 superficielle est à base d'un premier matériau semi-conducteur 13 cristallin. Dans cet exemple, le matériau semi-conducteur 13 cristallin est contraint et peut être par exemple du silicium contraint en tension.

Plusieurs autres couches semi-conductrices sont réalisées sur la couche semi-conductrice 12 superficielle, par exemple par plusieurs épitaxies successives, et forment avec cette dernière un empilement semi-conducteur. L'empilement semi-conducteur est composé d'une alternance d'une ou plusieurs couches 12 à base du premier matériau semi-conducteur 13 et d'une ou plusieurs couches 14, à base d'un deuxième matériau semi-conducteur 15. Le deuxième matériau semi-conducteur 15 est différent du premier matériau semi-conducteur 13 et peut être choisi de sorte à pouvoir être gravé sélectivement vis-à-vis du premier matériau semi-conducteur. Le deuxième matériau semi-conducteur 15 peut être par exemple du Si₁₋ₓGeₓ avec x > 0.

Une fois l'empilement semi-conducteur réalisé, on grave les couches 12, 14 de ce dernier de manière à former au moins une structure 17 semi-conductrice comprenant une alternance d'éléments semi-conducteurs 20₁, 20₂,...,20ₖ, 20ₖ₊₁ superposés à base du premier matériau semi-conducteur 13 et du deuxième matériau semi-conducteur 15, et au moins une autre structure 19 comprenant une alternance d'éléments semi-conducteurs superposés 20₁, 20₂,...,20ₖ, 20ₖ₊₁ à base du premier matériau semi-conducteur 13 et du deuxième matériau semi-conducteur 15. Suivant le rapport entre leurs largeurs W et leurs longueurs L respectives, les éléments semi-conducteurs 20₁, 20₂,...,20ₖ, 20ₖ₊₁, peuvent être par exemple sous forme de nano-fils, ou de barreaux, ou de membranes parallèles au plan principal du substrat. Le plan principal du substrat est ici défini comme un plan passant par ce dernier et qui est parallèle au plan [0 ; x ; y] du repère orthogonal [0 ; x ; y ; z] donné sur les figures.

Les structures 17 et 19 peuvent être rattachées l'une à l'autre par l'intermédiaire d'au moins un bloc 18 d'ancrage formé également dans l'empilement de couches semi-conductrices 12, 14.

La structure 17 est prévue sur le substrat dans une région R₁ dans laquelle un ou plusieurs transistors d'un type donné, par exemple de type P sont prévus, tandis que l'autre structure 19 est réalisée sur le substrat dans une autre région R₂ dans laquelle un ou plusieurs transistors d'un autre type, par exemple de type N sont prévus.

Du fait de la contrainte initiale de la couche superficielle 12 du substrat, les éléments semi-conducteurs 20₁, 20₃,..., 20ₖ₊₁, à base du premier matériau semi-conducteur 13 dans les structures 17 et 19 sont contraints, par exemple en tension.

Sur la figure 1A, les structures semi-conductrices 17 et 19 sont représentées selon une vue dessus, tandis que sur la figure 1B, seule la structure 17 est représentée selon une vue en coupe transversale B'B. La figure 1C donne, quant à elle, une vue selon une coupe longitudinale A'A de cette même structure 17.

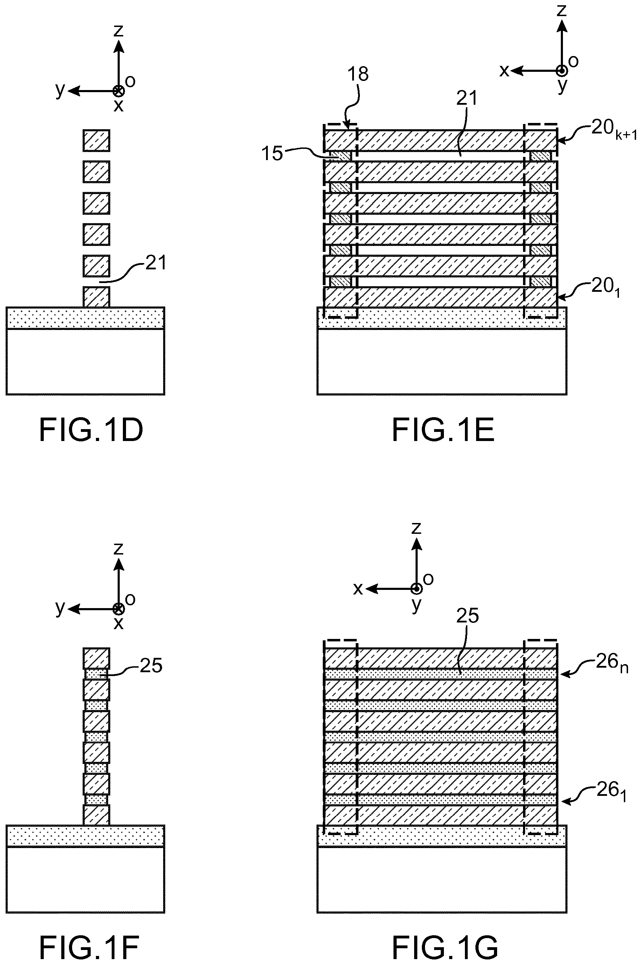

On effectue ensuite une gravure sélective du deuxième matériau semi-conducteur 15 vis-à-vis du premier matériau semi-conducteur 13 de manière à retirer au moins partiellement le deuxième matériau semi-conducteur 15 de la structure 17 et éventuellement de l'autre structure 19 lorsque celle-ci est également dévoilée lors de cette gravure (figures 1D et 1E).

Lorsque le deuxième matériau semi-conducteur 15 est du Si₁₋ₓGeₓ son retrait peut être effectué par exemple à l'aide d'une gravure isotrope à base de plasma CF₄ + O₂.

Dans les structures 17 et 19, des portions retirées du deuxième matériau semi-conducteur 15 forment des espaces vides 21 entre les éléments 20₁, 20₃,..., 20ₖ₊₁, à base du premier matériau semi-conducteur 13.

Pour permettre de maintenir les structures 17, 19 malgré cette gravure, des blocs d'ancrage 18 situées à leurs extrémité peuvent être prévues avec des dimensions dans un plan parallèle au plan principal du substrat plus importantes que celles W, L des structures 17, 19. Ainsi, la gravure sélective du deuxième matériau semi-conducteur 15 est de préférence réalisée de sorte que des zones à base du deuxième matériau semi-conducteur 15 sont conservées dans les blocs 18 d'ancrage. Les blocs d'ancrage 18 peuvent être sacrificiels et situés à des emplacements de futurs blocs de source et de drain des transistors.

On remplit ensuite les espaces vides 21 d'un matériau diélectrique 25 tel que par exemple du SiO₂ ou de l'oxyde de silicium dopé au Bore et/ou au Phosphore (figures 1F et 1G). Le matériau diélectrique 25 est intercalé entre les éléments 20₁, 20₃,..., 20ₖ₊₁, à base du premier matériau semi-conducteur 13 et est en contact avec ces éléments 20₁, 20₃,..., 20ₖ₊₁.

Une gravure partielle du matériau diélectrique 25 et sélective vis-à-vis du premier matériau semi-conducteur 13 peut être ensuite effectuée afin de former des éléments isolants 26₁,...,26ₙ (n un entier tel que n> 1) de remplacement sensiblement de mêmes dimensions que les éléments 20₂,..., 20ₖ à base du deuxième matériau semi-conducteur qui viennent d'être retirés. Dans un cas par exemple où le matériau diélectrique 25 est du SiO₂ et le premier matériau semi-conducteur 13 est du Si cette gravure peut être effectuée par exemple à l'aide de CHF₃ dans un réacteur ICP (pour « inductive coupled plasma ») tel que cela est décrit dans le document de N. R. Rueger, et al. J. Vac. Sci. Technol. A 17,,5..., Sep/Oct. 1999.

Dans l'exemple de réalisation de la figure 1G, chaque élément isolant 26₁,...,26ₙ en matériau diélectrique 25 s'étend entre deux éléments 20₁, 20₃,..., 20ₖ₊₁, à base du premier matériau semi-conducteur 13, dans une même direction que ces éléments 20₁, 20₃,..., 20ₖ₊₁.

A ce stade du procédé, les éléments semi-conducteurs 20₁, 20₃,..., 20ₖ₊₁ à base du premier semi-conducteur 13 peuvent être contraints en tension, tandis que les éléments à isolants 26₁,...,26ₙ à base matériau diélectrique 25 peuvent être sujets à une légère contrainte en compression.

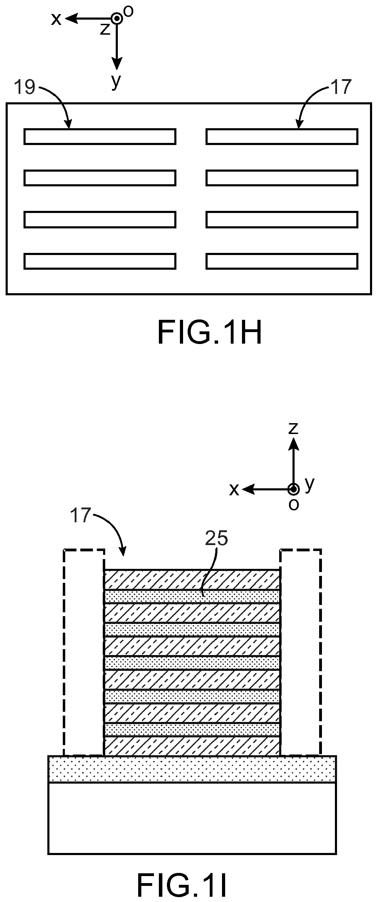

On peut ensuite effectuer un retrait du ou des blocs d'ancrage 18 et en particulier de celui séparant les structures 17 et 19 (figures 1H et 1I). Cela peut être réalisé au moyen d'étapes photolithographie et de gravure à travers un masque doté d'une ou plusieurs ouvertures dévoilant les blocs d'ancrage 18.

On forme ensuite sur la structure 17 une zone 31 de mise en contrainte à base d'un matériau 33 ayant une contrainte intrinsèque. Dans cet exemple, le matériau 33 est un matériau diélectrique contraint en tension, par exemple du SiₓN_{y} contraint en tension. Dans cet exemple de réalisation où l'on cherche à relaxer la structure 17, la zone 31 de mise en contrainte est prévue pour appliquer une contrainte dans le matériau 13 des éléments semi-conducteurs 20₁, 20₃,..., 20ₖ₊₁ qui s'oppose à celle de la couche superficielle 12 et dans les éléments semi-conducteurs 20₁, 20₃,..., 20ₖ₊₁ après croissance de l'empilement de couches semi-conductrices. La zone 31 de mise en contrainte est réalisée sur la région R₁ dans laquelle un ou plusieurs transistors de type N sont prévus.

Dans le même temps, où l'on vise à maintenir une contrainte dans l'autre structure 19, la zone 31 de mise en contrainte n'est pas prévue ou conservée sur cette autre structure 19.

Pour obtenir un tel agencement, le matériau 33 peut être déposé sur les régions R₁ et R₂ puis retiré en regard de l'autre région R₂, par exemple par photolithographie puis gravure.

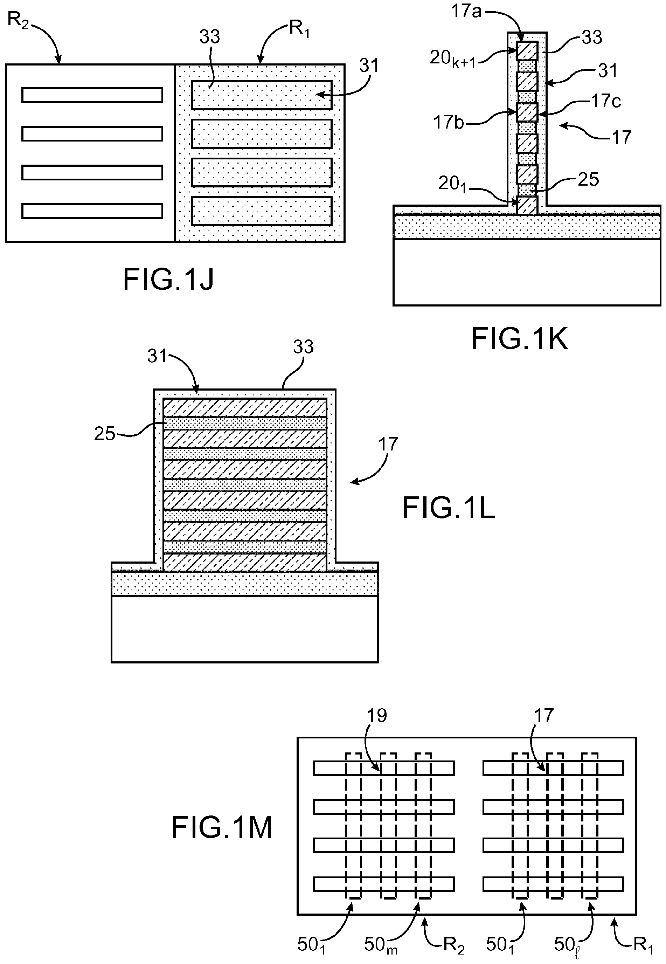

La zone 31 de mise en contrainte ainsi formée recouvre la structure 17 et s'étend en particulier sur une face supérieure 17a et des faces latérales 17b, 17c de la structure 17, tandis que l'autre structure 19 n'est pas recouverte par cette zone 31 (figures 1J, 1K, et 1L).

Ensuite, on effectue un recuit thermique dont la température et la durée sont prévues de sorte à modifier le comportement visco-élastique du matériau diélectrique 25 de sorte à le faire fluer et à le relaxer. Ce fluage est apte à entrainer une modification de l'état de contrainte dans les éléments 20₁, 20₃,..., 20ₖ₊₁ de la première structure 17 qui sont à base du premier matériau semi-conducteur 13. Le matériau 33 de la zone de mise en contrainte est choisi de préférence avec une température de fusion élevée de telle sorte qu'il ne flue pas lors du recuit thermique destiné à faire fluer le matériau diélectrique 25.

Le recuit thermique du matériau diélectrique 25 peut être prévu à une température et selon une durée adaptées pour permettre au matériau semi-conducteur 13 de subir une variation de contrainte d'au moins 1GPa si on part d'un substrat sSOI avec une contrainte de 1.4 GPa.

Un tel recuit peut être réalisé par exemple à une température comprise entre 1000°C et 1400°C pendant une durée par exemple de l'ordre de 2h lorsque le matériau diélectrique 25 réalisé est du SiO₂.

Lorsque le matériau diélectrique 25 est à base d'oxyde de silicium dopé par exemple au Phosphore ou au Bore ou au Phosphore et au Bore tel que du BPSG (pour « Boron and Phosphorous Doped Glass »), une gamme de températures moins élevées de recuit peut être avantageusement utilisée. On peut par exemple réaliser un recuit à une température comprise entre 500°C et 800°C pendant une durée par exemple de l'ordre de 2h lorsque le matériau diélectrique 25 est du BPSG.

Dans cet exemple de réalisation, grâce au recuit thermique de fluage du matériau diélectrique 25 qui est intercalé entre les éléments 20₁, 20₃,..., 20ₖ₊₁, ces éléments 20₁, 20₃,..., 20ₖ₊₁ de la structure 17 à base du premier matériau semi-conducteur 13 initialement contraint en tension sont relaxés. A l'aide d'un tel recuit on amplifie ainsi l'effet de la zone 31 de mise en contrainte sur la structure 17.

Une fois le recuit réalisé, on peut ensuite retirer la zone 31 de mise en contrainte à base du matériau 33 dans la région R₂ des transistors de type N. Ce retrait peut être effectué par exemple par gravure humide à l'aide d'acide phosphorique chaud lorsque le matériau 33 est à base de nitrure de silicium.

Dans cet exemple de réalisation, on forme ainsi une structure 17 relaxée dans la région R₁ du substrat prévue pour former une région de canal d'un transistor de type P, tandis que dans la région R₂ une structure 19 contrainte en tension est conservée pour former une région de canal d'un transistor de type N.

On peut ensuite compléter la formation des transistors en réalisant notamment un ou plusieurs blocs 50₁, ..., 50ₘ, de grilles sur la structure 17 et un ou plusieurs blocs 50₁, ...,50₁ sur l'autre structure 19 (figure 1M).

Ces blocs 50₁, ..., 50ₘ, de grilles peuvent être agencés contre les faces latérales et la face supérieure des structures 17 et 19 de manière à les enrober.

Dans l'exemple de réalisation illustré sur les figures 1A-1M, les régions de canal du transistor de type P et du transistor de type N sont formées respectivement de plusieurs structures semi-conductrices juxtaposées identiques à la structure 17 et de plusieurs structures semi-conductrices juxtaposées identiques à l'autre structure 19. Le nombre de structures semi-conductrices pour former la région de canal des transistors n'est pas limité et peut éventuellement varier d'un transistor à l'autre.

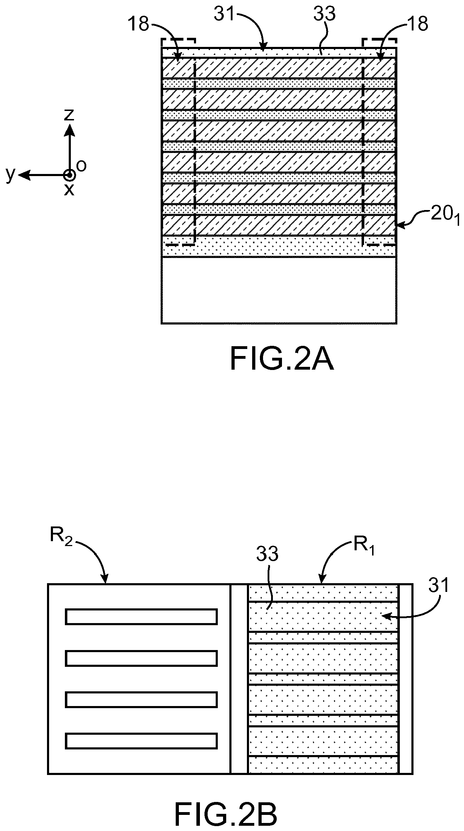

Une variante de l'exemple de procédé qui vient d'être décrit est illustrée sur les figures 2A-2B. Pour cette variante, on reporte l'étape de retrait du ou des blocs d'ancrage 18 disposés entre les structures semi-conductrices 17 et 19.

Une fois avoir effectué les étapes décrites précédemment en liaison avec les figures 1A-1G et remplacé des portions du deuxième matériau semi-conducteur 15 par le matériau diélectrique 25 entre les éléments à base du premier matériau semi-conducteur 13, on réalise la zone 31 de mise en contrainte. Pour cela, le matériau 33 à base de matériau 33 ayant une contrainte élastique intrinsèque est déposé sur les régions R₁ et R₂ (figure 2A).

Ensuite, ce matériau 33 est retiré dans une zone située en regard du ou des blocs d'ancrage 18.

On peut alors retirer le ou les blocs d'ancrage 18 pargravure en se servant de la zone 31 de mise en contrainte comme d'un masque de protection à la gravure.

Puis, on retire le matériau 33 en regard de l'autre région R₂ (figure 2B).

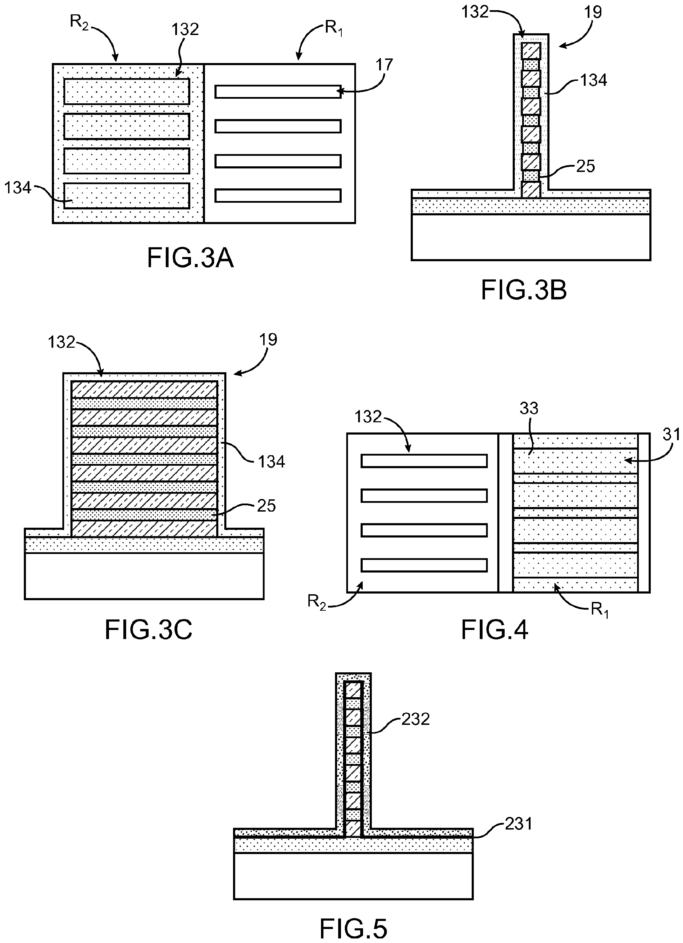

Un autre exemple de réalisation, illustré sur les figures 3A-3B, prévoit après avoir effectué les étapes décrites précédemment en liaison avec les figures 1A-1I et retiré le ou les blocs d'ancrage 18, de réaliser une zone 132 de mise en contrainte sur la région R₂ dans laquelle un ou plusieurs transistors de type N sont prévus.

La zone 132 de mise en contrainte est cette fois à base d'un matériau 134 ayant une contrainte intrinsèque opposée à celle utilisée dans les exemples précédents et formée sur la première région R₁. Dans cet exemple, la zone 132 de mise en contrainte est une zone à base d'un matériau 134 diélectrique contraint en compression tel que par exemple du SiₓN_{y} contraint en compression.

Pour former cette zone 132, le matériau 134 peut être déposé sur les régions R₂ et R₁ puis retiré en regard de la région R₁, par exemple par photolithographie puis gravure. La figure 3A donne une vue de dessus du dispositif en cours de réalisation. Sur les figures 3B et 3C seule l'autre structure 19 est représentée respectivement selon une vue en coupe transversale et selon une coupe longitudinale. Dans cet exemple, la zone 132 de mise en contrainte permet de créer une contrainte en tension dans les éléments à base du premier matériau semi-conducteur 13 de l'autre structure 19.

Ensuite, on effectue l'étape de recuit thermique à haute température de manière à faire fluer ou à relaxer le matériau diélectrique 25 interposé entre les éléments à base du premier matériau semi-conducteur 13.

Le fluage ou la relaxation du matériau diélectrique 25 agencé dans l'empilement et intercalé entre les éléments semi-conducteurs entraine une modification de la contrainte dans ces éléments à base du premier matériau semi-conducteur 13 de l'autre structure 19.

Un tel recuit peut être réalisé par exemple à une température comprise entre 1000°C et 1400°C pendant une durée par exemple de l'ordre de 2h lorsque le matériau diélectrique 25 réalisé est du SiO₂.

Grâce au fluage du matériau diélectrique 25, on augmente ici la contrainte en tension engendrée par le biais de la zone 132 de mise en contrainte dans les éléments de la structure 19 qui sont à base du premier matériau semi-conducteur 13.

Ainsi, dans l'exemple de réalisation qui vient d'être décrit, la modification de contrainte obtenue par recuit thermique du matériau diélectrique 25 permet d'accroitre une contrainte en tension induite dans la structure 19 du ou des transistors de type N.

Cet autre exemple de réalisation illustré en liaison avec les figures 1A-1C peut être combiné avec celui décrit en liaison avec les figures 1K-1M pour permettre de relaxer la structure 17 et de contraindre davantage en tension la structure 19.

Les étapes décrites en liaison avec les figures 3A-3C peuvent être ainsi réalisées avant celles décrites en liaison avec les figures 1K-1M ou après celles décrites en liaison avec les figures 1K-1M.

Dans l'exemple de réalisation illustré sur la figure 4, on forme dans la région R₁ sur la structure 17 une zone 31 de mise en contrainte à base d'un matériau 33 ayant une contrainte intrinsèque en tension, par exemple du nitrure de silicium contraint en tension, tandis que dans la région R₂ on forme sur l'autre structure 19 une autre zone 132 de mise en contrainte à base d'un matériau 434 ayant une contrainte intrinsèque opposée par exemple du nitrure de silicium contraint en compression.

Ensuite, on effectue le recuit de manière à faire fluer le matériau diélectrique 25 dans les structures 17 et 19 et imposer une contrainte en compression dans le semi-conducteur de la structure 17 tout en accroissant la contrainte en tension dans le semi-conducteur de la structure 19.

Il est également possible, en variante de l'exemple de procédé décrit précédemment en liaison avec les figures 1A-1M, de contraindre en compression la structure 17. Le substrat de départ peut dans ce cas être un substrat de type SOl avec une couche superficielle 12 relaxée.

Une variante de l'exemple de réalisation qui a été décrit précédemment en liaison avec les figures 3A-3C prévoit de partir d'un substrat de type SiGeOl, avec cette fois une couche superficielle 12 à base de SiGe.

L'empilement semi-conducteur à partir duquel on réalise les structures 17, 19 peut être dans ce cas formé d'une alternance de couches 12 à base de Si_{1-y}Ge_{y} avec y > 0 et de couches 14 à base de Si.

Dans ce cas, le retrait par gravure sélective du deuxième matériau semi-conducteur 15 dans les structures 17, 19 peut être réalisée par exemple à l'aide d'un procédé tel que décrit par exemple dans le document de Stéphan Borel et al. « Control of selectivity between SiGe and Si in Isotropic Etching Processes », Japanese Journal of Applied Physics, 2004.

On forme ensuite sur celle-ci une zone de contrainte en tension par exemple du nitrure contraint en tension sur la structure 19 afin de la contraindre en compression.

Puis, on réalise le recuit thermique de fluage ou de relaxation du matériau diélectrique 25 afin d'augmenter la contrainte en compression dans cette structure 19.

Une variante de l'exemple de réalisation qui a été décrit précédemment en liaison avec les figures 1A-1M prévoit de partir d'un substrat de type sSiGeOl, avec cette fois une couche superficielle 12 à base de SiGe ayant une contrainte intrinsèque en compression.

Ensuite, dans le cas où l'on souhaite relaxer une structure 17, on forme sur celle-ci une zone de contrainte en compression par exemple du nitrure contraint en compression avant de réaliser le recuit thermique de fluage ou de relaxation du matériau diélectrique 25.

Une zone de mise en contrainte destinée à recouvrir l'empilement formé d'une alternance d'éléments semi-conducteurs et d'éléments en matériau diélectrique 25 peut être formée à base d'un autre matériau que le nitrure de silicium. Il est par exemple possible d'utiliser une couche de TiN comme couche de mise en tension.

Du fait du caractère réfractaire du TiN et de la différence de coefficient de dilation thermique entre le TiN et le substrat en silicium (Si), en montant en température le TiN garde un comportement élastique et devient de plus en plus compressif avec une augmentation de l'ordre de -2.1MPA/°C. Si la contrainte de départ est de -500MPa à 30°C, à 1030°C, elle peut atteindre une valeur de l'ordre de -2600 GPa.

Lorsque le TiN est déposé par technique PVD (pour « Physical Vapor Deposition »), celui-ci est généralement compressif à température ambiante. Dans le cas où l'on dépose une couche de mise en contrainte à base de TiN par CVD (pour « Chemical Vapor Deposition »), la contrainte compressive initiale de la couche de TiN peut être plus faible.

Afin d'éviter une contamination des éléments semi-conducteurs, lorsqu'on forme une zone 232 de mise en contrainte en TiN, on peut prévoir une fine couche barrière 231 à base de matériau isolant entre la zone 232 de mise en contrainte et la structure formée d'une alternance d'éléments semi-conducteur et de matériau diélectrique 25. La couche barrière 231 est par exemple une couche d'épaisseur inférieure 1 nm à base de SiO₂ (figure 5).

## Revendications

1. Procédé de réalisation d'un dispositif microélectronique doté d'au moins un premier transistor ayant une première structure (17, 19) de canal à éléments semi-conducteurs disposés les uns au-dessus des autres, le procédé comprenant des étapes consistant à :
a) prévoir sur un substrat, au moins une première structure semi-conductrice (17, 19) formée d'un empilement semi-conducteur comprenant une alternance d'éléments à base d'au moins un premier matériau semi-conducteur (13) et d'éléments à base d'au moins un deuxième matériau semi-conducteur (15) différent du premier matériau semi-conducteur, puis
b) retirer dans la première structure (17, 19), par gravure sélective : des portions du deuxième matériau semi-conducteur, les portions retirées du deuxième matériau semi-conducteur formant un ou plusieurs espaces vides (21),
c) remplir les espaces vides à l'aide d'un matériau diélectrique (25)
d) former, sur la première structure : une zone (31, 132) de mise en contrainte à base d'un premier matériau contraint (33, 134) ayant une contrainte intrinsèque,
e) effectuer un recuit thermique adapté pour faire fluer le matériau diélectrique (25), et entrainer une modification de l'état de contrainte des éléments à base du premier matériau semi-conducteur (13) dans la première structure (17).

2. Procédé selon la revendication 1, dans lequel le dispositif microélectronique est doté d'au moins un deuxième transistor ayant une deuxième structure de canal à éléments semi-conducteurs disposés les uns au-dessus des autres, au moins une deuxième structure semi-conductrice (19, 17) formée dans l'empilement semi-conducteur et comprenant une alternance d'éléments à base d'au moins un premier matériau semi-conducteur (13) et d'éléments à base d'au moins un deuxième matériau semi-conducteur (15) différent du premier matériau semi-conducteur étant prévue à l'étape a),
l'étape d) comprenant des étapes de :
- dépôt du matériau contraint (33,134) sur la première structure et sur la deuxième structure, puis
- retrait du premier matériau contraint sur la deuxième structure.

3. Procédé selon la revendication 2, comprenant en outre des étapes consistant à :
- former sur la deuxième structure : une zone de mise en contrainte à base d'un deuxième matériau contraint ayant une contrainte intrinsèque opposée à celle du premier matériau contraint.

4. Procédé selon l'une des revendications 2 ou 3, dans lequel la première structure et la deuxième structure prévues à l'étape a) sont rattachées par le biais d'au moins un bloc d'ancrage (18), le bloc d'ancrage étant retiré préalablement à l'étape e).

5. Procédé selon la revendication 4, dans lequel le bloc d'ancrage est retiré après l'étape d) par gravure en se servant de la zone de mise en contrainte comme d'un masque de protection à cette gravure.

6. Procédé selon l'une des revendications 1 à 5, dans lequel le substrat prévu à l'étape a) est un substrat de type semi-conducteur contraint sur isolant doté d'une couche semi-conductrice superficielle (12) contrainte, la modification d'état de contrainte à l'étape e) étant une relaxation des éléments à base du premier matériau semi-conducteur (13).

7. Procédé selon l'une des revendications 1 à 5, dans lequel le substrat prévu à l'étape a) est un substrat de type semi-conducteur sur isolant doté d'une couche semi-conductrice superficielle relaxée, la modification d'état de contrainte à l'étape e) étant une augmentation d'un état de contrainte induit par la zone (31) de mise en contrainte dans les éléments à base du premier matériau semi-conducteur (13).

8. Procédé selon l'une des revendications 1 à 7, dans lequel le matériau diélectrique est à base de SiO₂ ou d'oxyde de silicium dopé.

9. Procédé selon l'une des revendications 1 à 8, dans lequel le premier matériau semi-conducteur (13) est du Si tandis que le deuxième matériau semi-conducteur (15) est du Si_{1-y}Ge_{y} avec y > 0 ou dans lequel le premier matériau semi-conducteur (13) est à du Si₁₋ₓGeₓ avec x > 0, tandis que le deuxième matériau semi-conducteur (15) est du Si.

## Patentansprüche

1. Verfahren zur Herstellung einer mikroelektronischen Vorrichtung, die mit wenigstens einem ersten Transistor versehen ist, der eine erste Kanalstruktur (17, 19) mit Halbleiterelementen aufweist, die aufeinander angeordnet sind, wobei das Verfahren die folgenden Schritte umfasst:
a) Bereitstellen, auf einem Substrat, wenigstens einer ersten Halbleiterstruktur (17, 19), die aus einem Halbleiterstapel gebildet ist, der eine alternierende Anordnung von Elementen auf Basis wenigstens eines ersten Halbleitermaterials (13) und von Elementen auf Basis wenigstens eines zweiten Halbleitermaterials (15) umfasst, das von dem ersten Halbleitermaterial verschieden ist, und dann
b) Entfernen von Bereichen des zweiten Halbleitermaterials in der ersten Struktur (17, 19) durch selektives Ätzen, wobei die entfernten Bereich des zweiten Halbleitermaterials einen oder mehrere Leerräume (21) bilden,
c) Füllen der Leerräume mit Hilfe eines dielektrischen Materials (25)
d) Bilden , auf der ersten Struktur, einer Zone (31, 132) zum unter Spannung Setzen auf Basis eines ersten gespannten Materials (33, 134), das eine intrinsische Spannung hat,
e) Durchführen eines thermischen Glühens, das dazu ausgelegt ist, das dielektrische Material (25) fließen zu lassen, und Bewirken einer Modifikation des Spannungszustands der Elemente auf Basis des ersten Halbleitermaterials (13) in der ersten Struktur (17).

2. Verfahren nach Anspruch 1, bei dem die mikroelektronische Vorrichtung mit wenigstens einem zweiten Transistor versehen ist, der eine zweite Kanalstruktur mit Halbleiterelementen aufweist, die aufeinander angeordnet sind, wobei im Schritt a) wenigstens eine zweite Halbleiterstruktur (19, 17) vorgesehen ist, die in dem Halbleiterstapel gebildet ist und eine alternierende Anordnung von Elementen auf Basis wenigstens eines ersten Halbleitermaterials (13) und von Elementen auf Basis wenigstens eines zweiten Halbleitermaterials (15) umfasst, das vom ersten Halbleitermaterial verschieden ist,
wobei der Schritt d) die folgenden Schritte umfasst:
- Aufbringen von gespanntem Material (33, 134) auf die erste Struktur und auf die zweite Struktur, und dann
- Entfernen des ersten gespannten Materials auf der zweiten Struktur.

3. Verfahren nach Anspruch 2, ferner umfassend die folgenden Schritte:
- Bilden, auf der zweiten Struktur, einer Zone zum unter Spannung Setzen auf Basis eines zweiten gespannten Materials, das eine intrinsische Spannung hat, die jener des ersten gespannten Materials entgegengesetzt ist.

4. Verfahren nach einem der Ansprüche 2 oder 3, bei dem die erste Struktur und die zweite Struktur, die im Schritt a) vorgesehen sind, mittels wenigstens eines Verankerungsblocks (18) aneinander angebracht sind, wobei der Verankerungsblock vor dem Schritt e) entfernt wird.

5. Verfahren nach Anspruch 4, bei dem der Verankerungsblock nach dem Schritt d) durch Ätzen entfernt wird, wobei man sich der Zone zum unter Spannung Setzen als eine Schutzmaske bei diesem Ätzen bedient.

6. Verfahren nach einem der Ansprüche 1 bis 5, bei dem das im Schritt a) vorgesehene Substrat ein Substrat vom Typ gespannter Halbleiter auf Isolator ist, das mit einer gespannten Halbleiter-Oberflächenschicht (12) versehen ist, wobei die Modifikation des Spannungszustands im Schritt e) eine Relaxation der Elemente auf Basis des ersten Halbleitermaterials (13) ist.

7. Verfahren nach einem der Ansprüche 1 bis 5, bei dem das im Schritt a) vorgesehene Substrat ein Substrat vom Typ Halbleiter auf Isolator ist, das mit einer relaxierten Oberflächenhalbleiterschicht versehen ist, wobei die Modifikation des Spannungszustands im Schritt e) eine Vergrößerung eines Spannungszustands ist, der durch die Zone (31) zum unter Spannung Setzen in den Elementen auf Basis des ersten Halbleitermaterials (13) induziert wird.

8. Verfahren nach einem der Ansprüche 1 bis 7, bei dem das dielektrische Material auf Basis von SiO₂ oder von dotiertem Siliziumoxid ist.

9. Verfahren nach einem der Ansprüche 1 bis 8, bei dem das erste Halbleitermaterial (13) Si ist, wohingegen das zweite Halbleitermaterial (15) Si_{1-y}Ge_{y} ist, mit y > 0, oder bei dem das erste Halbleitermaterial (13) Si₁₋ₓGeₓ ist, mit x > 0, wohingegen das zweite Halbleitermaterial (15) Si ist.

## Claims

1. A method for making a microelectronic device provided with at least one first transistor with a first channel structure (17, 19) formed from semiconducting elements located above each other, the method comprising steps to:
a) provide at least one first semiconducting structure (17, 19) on a substrate, formed from a semiconducting stack comprising an alternation of elements based on at least one first semiconducting material (13) and elements based on at least one second semiconducting material (15) different from the first semiconducting material, then
b) remove portions of the second semiconducting material from the first structure (17,19) by selective etching, the removed portions of the second semiconducting material forming one or several empty spaces (21),
c) fill in the empty spaces with a dielectric material (25),
d) form a straining zone (31, 132) on the first structure, based on a first strained material (33, 134) with an intrinsic strain,
e) perform appropriate thermal annealing so as to make the dielectric material creep (25), and cause a change in the strain state of elements based on the first semiconducting material (13) in the first structure (17).

2. The method according to claim 1, wherein the microelectronic device is provided with at least one second transistor with a second channel structure formed from semiconducting elements located above each other, at least one second semiconducting structure (19, 17) formed in the semiconducting stack and comprising an alternation of elements based on at least one first semiconducting material (13) and elements based on at least one second semiconducting material different from the first semiconducting material (15) provided in step a),
step d) comprising steps to:
- deposit the first strained material (33, 134) on the first structure and on the second structure, then
- remove the first strained material from the second structure.

3. The method according to claim 2, further comprising steps to:
- form a straining zone on the second structure based on a second strained material with an intrinsic strain opposite the strain in the first strained material.

4. The method according to any of the claims 2 or 3, wherein the first structure and the second structure provided in step a) are attached to each other by means of at least one anchor block (18), the anchor block being removed before step e).

5. The method according to claim 4, wherein the anchor block is removed after step d) by etching making use of the straining zone as a protective stencil for this etching.

6. The method according to any of the claims 1 to 5, wherein the substrate provided in step a) is a strained semiconducting on insulator type substrate provided with a strained surface semiconducting layer (12), the change in the strain state in step e) being relaxation of the elements based on the first semiconducting material (13).

7. The method according to any of the claims 1 to 5, wherein the substrate provided in step a) is a strained semiconducting on insulator type substrate provided with a relaxed surface semiconducting layer (12), the change in the strain state in step e) being an increase in a strain state induced by the straining zone in the elements based on the first semiconducting material (13).

8. The method according to any of the claims 1 to 7, wherein the dielectric material is based on SiO₂ or doped silicon oxide.

9. The method according to any of the claims 1 to 8, wherein the first semiconducting material is Si while the second semiconducting material is Si_{1-y}Ge_{y} where y > 0 or in which the first semiconducting material is Si₁₋ₓGeₓ where x > 0, while the second semiconducting material is Si.
